# EUROPEAN PATENT APPLICATION

(11) **EP 3 376 837 A1**
(43) Date of publication of application: **19.09.2018**
(21) Application number: 17382136.4
(22) Date of filing: 17.03.2017
(51) Int. Cl.: H05K 1/02, F21S 8/10, H01L 23/40, F21V 29/76, F21V 29/83

(54) **LIGHTING MODULE WITH HEAT DISSIPATION MEANS ON PCB AND METHOD FOR PRODUCING THEREOF**

(71) Applicant: Valeo Iluminacion, 23600 Martos (ES)
(72) Inventor: ROLDAN, Jose-David, 23600 MARTOS (ES); MARTINEZ-PEREZ, Jose-Ramon, 23600 MARTOS (ES); PENA, Miguel-Angel, 23600 MARTOS (ES); SANTAELLA, Juan-Jose, 23600 MARTOS (ES); LARA-CABEZA, Juan, 23000 MARTOS (ES); ILLAN, Antonio Domingo, 23600 MARTOS (ES); ARJONA, Jaime, 23600 MARTOS (ES)

(57) **Abstract**

Lighting module for an automotive vehicle, comprising: a printed circuit board; and heat dissipation means comprising at least one metallic sheet; the at least one metallic sheet is stuck on the printed circuit board and the at least one metallic sheet comprises at least a first portion and a second portion which are not coplanar with each other. And a method for producing a lighting module for an automotive vehicle, comprising: providing a printed circuit board; providing heat dissipation means comprising at least one metallic sheet; shaping the at least one metallic sheet into at least a first portion and a second portion which are not coplanar with each other; and sticking the at least one metallic sheet on the printed circuit board.

## Description

### TECHNICAL FIELD

The present invention relates to the field of lighting modules suitable for automotive vehicles and which comprise heat dissipation means stuck on the printed circuit board (PCB).

### STATE OF THE ART

The lighting devices of a motor vehicle tend to produce large amounts of heat. The heat produced must be somehow released from the lighting devices, otherwise they may end up not operating correctly. The light provided by an overheated lighting device may become dimmer, start flickering or even not be provided at all, that is, the lighting device may stop working. Even though this problem is common to any lighting device of a motor vehicle, it particularly affects the lighting devices that provide lighting for long -and continuous- periods of time, this is the case of, for example, low beam lamps, daylight running lamps, or position lamps.

Heatsinks are commonly incorporated to the lighting modules of lighting devices so that the dissipation of heat may be enhanced and, hence, lengthen the useful life of the lighting modules and the light sources thereof.

A lighting module generally includes a PCB for hosting electronic circuits and/or components enabling the provision of light by the respective light source/s. The lighting module further includes a metallic piece that is used both for attaching the lighting module to a structural part of a lighting device -e.g. a reflector, a housing, etc.-, and for supporting a heatsink. In fact, as the metallic piece sometimes also functions as a heat spreader, it may also be regarded as the base of the heatsink.

In this sense, the metallic piece of the lighting module is considered to be a structural element of the module. In many modules, said metallic piece is formed by means of a metallic injection molding process which is costly. This means that, in order to provide a heatsink that may dissipate the heat produced by the lighting device and which may make up a lighting device, the lighting module must be provided with the metallic piece, namely an additional element, whose manufacture moreover may be expensive.

There have been efforts in the prior art to provide modules or devices, for electronics in general, which are capable of dissipating heat in a rate sufficient to avoid overheating problems and which may simplify the overall implementation thereof.

For instance, patent document GB-2502148-A describes a heatsink that may be mounted on a printed circuit board. The heatsink features at least one channel whereby it may be mounted on the PCB. Accordingly, at least a cutout or an indentation is provided on the PCB in order to receive the heatsink -through the at least one channel-. When mounted on the PCB, the heatsink takes some space in the PCB thereby limiting the useful space for hosting electronic components.

Another example is patent document DE-102010023191-A1 related to a module comprising filters against electromagnetic interference. The module comprises a circuit board whereon the filters are hosted. The circuit board comprises a metal core and thermal connections thereto that permit the PCB to spread and dissipate the heat produced in the module.

These prior-art solutions, however, cannot cope with the amount of heat produced by a lighting device. In fact, the PCBs of some lighting modules are already provided with a metal core and yet they are not capable of dissipating the heat sufficiently rapidly; therefore, when heat starts to build up on the PCB, the lighting module does not operate in the nominal operating conditions, something which may lead to failures. In this regard, the use of insulated metal substrate (IMS) PCBs may result in an improvement on the heat dissipation over a standard PCB but a heatsink is still necessary to transfer heat to the environment and the physical medium thereof.

Accordingly, there is an interest in providing a lighting module for an automotive vehicle, that may dissipate heat produced by a light source thereof in a rate sufficient for the lighting module to maintain a temperature within a nominal operating temperature range, and whose manufacture is cost-effective.

### DESCRIPTION OF THE INVENTION

A first aspect of the invention relates to a lighting module for an automotive vehicle, comprising: a printed circuit board; and heat dissipation means comprising at least one metallic sheet; the at least one metallic sheet is stuck on the printed circuit board and the at least one metallic sheet comprises at least a first portion and a second portion which are not coplanar with each other.

The PCB of the lighting module comprises one or several devices and/or electronic components installed thereon which produce heat while they are active. One part of the heat is directly transferred to the physical medium of the environment, e.g. air, whereas the other part is transferred to the PCB. Therefore, the heat on the PCB generally builds up as the lighting module is functioning.

As the at least one metallic sheet is stuck on the PCB -generally on one side of the main sides of the PCB, a main side being regarded as a side having a larger footprint than one or more other sides of the PCB, for example a side on which electronic components are installed-, the physical contact between the at least one metallic sheet and the PCB provides a thermal conducting path for transferring heat from one surface to the other: the surface at a higher temperature transfers heat to the surface at a lower temperature. It is preferable that the at least one metallic sheet comprises a thermally conductive material so that the contacting surface of the at least one metallic sheet may be at a lower temperature. Therefore, a greater difference between the temperature of the PCB and that of the at least one metallic sheet may be achieved and, thus, more heat may be conducted and transferred to the at least one metallic sheet of the heat dissipation means.

The at least one metallic sheet is shaped to form a 3D volume. Therefore, once heat is transferred to the at least one metallic sheet, it is spread and conducted throughout the entire surface of the at least one metallic sheet (that is, throughout the entire 3D volume) so that the heat may be transferred to the physical medium of the environment, thereby releasing heat from the lighting module. In this sense, the at least one metallic sheet comprises the at least first portion, and the at least second portion that extends outwardly from the printed circuit board. The at least first portion may be coplanar with the printed circuit board whereas the at least second portion is not coplanar with the printed circuit board, so the at least first and second portions are not coplanar with each other.

In some embodiments, the heat dissipation means further comprise an adhesive interposed between the at least one metallic sheet and the printed circuit board with which the two stick together. Preferably, the adhesive is a thermal adhesive that increases the heat transfer between the two contacting surfaces, that is, the surfaces of both the PCB and the at least one metallic sheet which are in contact.

In some embodiments, the heat dissipation means further comprise screws for sticking the at least one metallic sheet on the printed circuit board. The screws attach the at least one metallic sheet to the printed circuit board.

In some embodiments, the heat dissipation means further comprise crimps for sticking the at least one metallic sheet on the printed circuit board. The at least one metallic sheet may be bent or deformed such that it attaches to the printed circuit board.

In some embodiments, the printed circuit board may comprise means for attaching an optical device to the printed circuit board, and/or means for attaching the lighting module to a lighting device, for example to a structural element thereof, a reflector, a light guide, or a housing.

The first means permit an optical device such as an LED module to be attached to the PCB using, for example but not limited to, screws, clips, ribs, etc. These means may also permit positioning and aligning the optical device relative to the PCB -and the lighting module itself- with sufficient precision, so no additional structural elements may be necessary in this regard.

The means for attaching the lighting module to a lighting device make the printed circuit board to further function as a mechanical interface between the lighting module and a lighting device -which may include the lighting module-. That is, the lighting module may not need an additional structural element, for example a metallic piece, which may support the lighting module within a lighting device. As a result, the weight of the lighting module and the overall weight of the corresponding lighting device may be reduced. These means may comprise, for example, holes for receiving screws.

By way of example, FR4 substrates commonly-used in electronics, e.g. 1 millimeter- or 1.6 millimeters- thick, may be used as the PCB of the lighting module, even if the PCB functions as a mechanical interface between the lighting module and a lighting device. However, it may be preferable to use thicker substrates so as to increase the rigidity and sturdiness of the PCB and the lighting module itself. Substrates other than FR4 may also be used instead; the printed circuit board may be provided in the form of a metal core PCB as well.

In some embodiments of the invention, the heat dissipation means do not comprise any heat dissipation element formed by metal injection molding. Since the at least one metallic sheet is provided as heat dissipation means and the PCB may also structurally support optical devices of a lighting device and/or even be used for attaching the lighting module to a lighting device, the lighting module may do without a supporting metallic piece formed by metal injection molding.

In some embodiments, the at least one metallic sheet comprises aluminum -or an alloy thereof- or copper -or an alloy thereof-. Both aluminum and copper are materials which provide a good trade-off between cost and thermal conductivity; the thermal conductivity of these materials may be in the order of 100 W/m K, and generally it is close to or greater than 200 W/m K.

The at least one metallic sheet may be shaped into the at least first portion and the at least second portion by means of one of: folding, bending, stamping, cutting, or a combination thereof.

Preferably, the at least one metallic sheet is shaped such that the at least first portion comprises a planar surface adapted to stick on the printed circuit board, and the at least second portion comprises a surface adapted to dissipate heat.

The planar surface of the at least first portion is to be in contact with the printed circuit board so that heat may be transferred to the at least one metallic sheet. Maximizing the surface of the at least one metallic sheet to be in contact with the PCB may result in a larger amount of heat being transferred to the at least one metallic sheet.

The surface adapted to dissipate heat preferably comprises one of a twisted shape, a curved shape, an accordion shape and a honeycomb shape. These shapes may advantageously transfer a large amount of heat to the surrounding physical medium.

In some embodiments, the printed circuit board is a metal core printed circuit board, for example an IMS PCB which comprises a metal core with high or relatively high thermal conductivity, for example a metal core made up of aluminum, copper, or an alloy thereof. The at least one metallic sheet is preferably stuck on the metal core of the PCB so that there may be a greater transference of heat between the PCB and the at least one metallic sheet thereby enhancing the heat dissipation.

A second aspect of the invention relates to a method for producing a lighting module for an automotive vehicle, comprising: providing a printed circuit board; providing heat dissipation means comprising at least one metallic sheet; shaping the at least one metallic sheet into at least a first portion and a second portion which are not coplanar with each other; and sticking the at least one metallic sheet on the printed circuit board.

The at least one metallic sheet is intended to first receive heat from the PCB and then release it from the lighting module by transferring the heat to the surrounding environment and the physical medium thereof, for instance air.

Accordingly, the at least one metallic sheet is shaped such that a large surface may be in contact with the physical medium and, therefore, ease the heat transfer to the environment. Particularly, shaping the at least one metallic sheet may comprise providing the at least first portion with a planar surface adapted to stick on the printed circuit board; and shaping the at least second portion so as to provide a surface adapted to dissipate heat. The surface adapted to dissipate heat preferably comprises one of a twisted shape, a curved shape, an accordion shape and a honeycomb shape.

The at least one metallic sheet, once it has been shaped, is stuck on the printed circuit board. In this sense, the heat dissipation means may comprise adhesive which permits sticking the metallic sheet on the PCB, and sticking the at least one metallic sheet on the printed circuit board comprises interposing the adhesive between the at least one metallic sheet and the printed circuit board. Preferably, said adhesive is a thermal adhesive that may enhance the conduction of heat between the contacting surfaces. The heat dissipation means may comprise screws and/or crimps for sticking the at least one metallic sheet on the printed circuit board thereby attaching the at least one metallic sheet to the printed circuit board.

In some embodiments, the method further comprises providing in the printed circuit board means for attaching an optical device to the printed circuit board and/or means for attaching the lighting module to a lighting device -e.g. a structural element thereof, a reflector, a light guide, a housing.

In some embodiments of the invention, the heat dissipation means do not comprise any heat dissipation element formed by metal injection molding. Accordingly, the costs incurred in producing the lighting module may be reduced; further, the weight of the produced lighting module is also reduced as, overall, the module comprises less structural elements.

In some embodiments, the at least one metallic sheet comprises one of: aluminum, copper, and an alloy thereof.

In some embodiments, shaping the at least one metallic sheet comprises one of: folding, bending, stamping, cutting, and a combination thereof.

Further, similar advantages as described for the first aspect of the invention may also be applicable to this aspect of the invention.

A third aspect of the invention relates to a lighting device for an automotive vehicle, comprising a lighting module according to the first aspect of the invention.

Another aspect of the invention relates to an automotive lamp comprising a lighting device according to the third aspect of the invention. The automotive lamp may be one of: a headlamp, a turn signal lamp, and a tail lamp.

A further aspect of the invention relates to a method for producing a lighting device for an automotive vehicle, comprising: producing a lighting module according to the method of the second aspect of the invention; and providing a light source.

### BRIEF DESCRIPTION OF THE DRAWINGS

To complete the description and in order to provide for a better understanding of the invention, a set of drawings is provided. Said drawings form an integral part of the description and illustrate embodiments of the invention, which should not be interpreted as restricting the scope of the invention, but just as examples of how the invention can be carried out. The drawings comprise the following figures:
Figures 1A-1C show a lighting module in accordance with an embodiment of the invention.
Figures 2A-2B show examples of heat dissipation means for a lighting module according to the present disclosure.
Figures 3A-3B show a lighting module in accordance with another embodiment of the invention.

### DESCRIPTION OF A WAY OF CARRYING OUT THE INVENTION

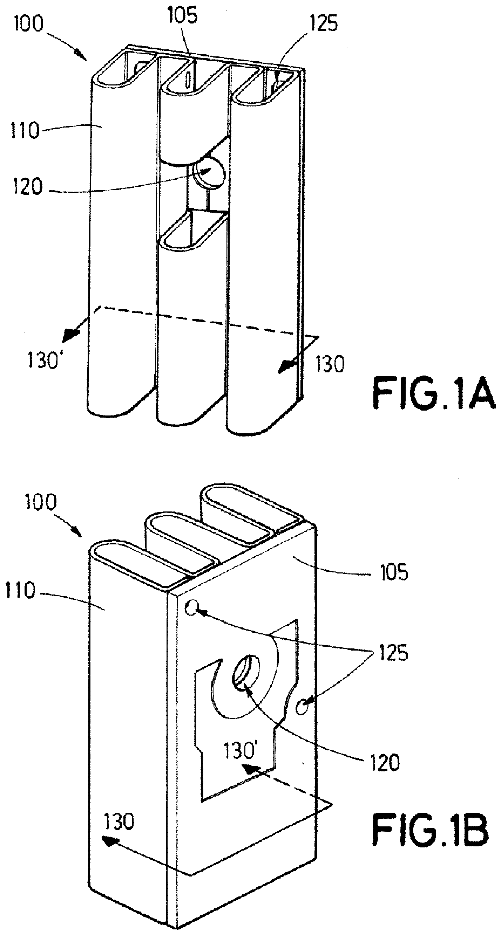

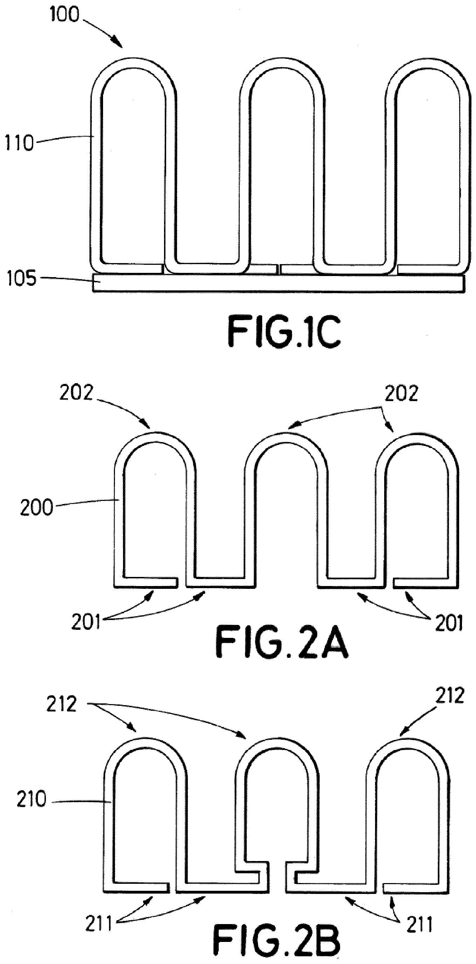

Figures 1A-1B show a lighting module 100 from two different angles, whereas Figure 1C shows the sectional view of the same lighting module 100 taken along line 130-130'.

The lighting module 100 comprises a printed circuit board 105, heat dissipation means, means 120 for attaching an optical device (not illustrated) to the printed circuit board 105, means 125 for attaching the lighting module 100 to a lighting device (not illustrated), and a light source (not illustrated) (e.g. comprising at least one LED, for example one LED, two LEDs, three LEDs, or even more than three LEDs).

The PCB 105 comprises at least one electrically insulating layer made up of dielectric material, and an electrically conductive layer (not illustrated) where electronic circuits and/or components may be soldered to. The PCB may comprise at least two electrically conductive layers, one on each of the two main sides of the PCB. The electrically conductive layer/s may be covered with a solder mask which protects the electrically conductive layer/s against oxidation.

The heat dissipation means comprise a metallic sheet 110. The metallic sheet 110 is stuck on a side of the PCB 105; said side may comprise an electrically conductive layer or an electrically insulating layer. In the embodiments in which the PCB comprises only one electrically conductive layer, the metallic sheet is preferably stuck on the side of the PCB not having the electrically conductive layer so that a larger footprint for soldering electronic components is available.

The heat produced by any electronic component, light source, or optical device in general -e.g. an LED module- which may be provided on the PCB is transferred to both the PCB 105 and the physical medium surrounding the device producing said heat -in most cases said physical medium is air-. The part of heat transferred to the PCB 105 may then be transferred to the heat dissipation means. The portion of the metallic sheet 110 which is in contact with the printed circuit board 105 -e.g. portions 201 and 211 of Figures 2A-2B- drives the heat towards the portion extending outwards from the PCB -e.g. portions 202 and 212 of Figures 2A-2B-; the portion extending outwardly from the PCB generally features a large surface not in contact with any other material or object so that it may transfer a larger amount of heat to the surrounding physical medium. Further, the portion -e.g. portions 201 and 211 of Figures 2A-2B- of the metallic sheet 110 in contact with the printed circuit board may be adhered to the PCB by means of a thermal adhesive (not illustrated) that enhances the transference of heat, thereby achieving a greater cooling effect on the printed circuit board and the devices and components installed thereon.

The means 120 for attaching an optical device to the printed circuit board 105 are provided in the form of at least one through hole traversing the PCB 105. An optical device of a lighting device comprising the lighting module 100 may be installed on the PCB 105 using the means 120 for attaching an optical device.

Further, the means 125 may be provided for attaching the lighting module 100 to the lighting device, for instance a structural part thereof. By way of example only, screws or bolts provided in the means 125 may attach the lighting module 100 to the lighting device. This means that the PCB 105 may also function as a mechanical interface between the lighting module 100 and the lighting device thereby suppressing the need for an additional structural element (e.g. a metallic piece formed with a metallic injection molding process). Consequently, the whole lighting module may be made lighter.

Figure 2A shows exemplary heat dissipation means that comprises a metallic sheet 200.

The metallic sheet 200 is folded and bent such that the at least two different parts or portions not coplanar with each other are provided thereby forming a 3D volume: a first portion 201 comprising at least one planar surface which is adapted to be stuck on a printed board circuit of a lighting module (and which is coplanar with the printed circuit board), and a second portion 202 comprising a surface which is adapted to dissipate heat (and which is not coplanar with the printed circuit board). The metallic sheet 200 may be folded and bent in a continuous manner so as to provide a plurality of planar surfaces and surfaces adapted to dissipate heat.

The planar surface/s -corresponding to the first portion 201-, in addition to serving for the purpose of sticking the metallic sheet 200 on the PCB, provide heat dissipation and/or spreading capabilities to the heat dissipation means. By increasing the surface in contact with the PCB, the transference of heat from the printed circuit board to the second portion 202 of the metallic sheet 200 may be improved.

The surface of the second portion 202 features an accordion shape or geometry. Such shape is regarded as a shape that transfers heat to the surrounding environment at a good rate due to the extended surface only in contact with the environment.

Figure 2B shows another exemplary heat dissipation means comprising a metallic sheet 210.

The metallic sheet 210 has been subject to a shaping process similar to the one of the metallic sheet 200. Accordingly, as a result of the different folds and bends, the first portion 211 and the second portion 212 of the metallic sheet 210 resemble the first and second portions 201 and 202 of the metallic sheet 200. However, the first portion 211 is provided with an extended planar surface, specifically in the part close to the fin in the middle, so that more heat may be transferred from the printed circuit board of a lighting module to the heat dissipation means.

As it is readily apparent to the reader, the surface of any of the second portions 202 and 212 may feature different shapes or geometries which may also be adapted to dissipate heat conveniently. The surface may also be tailored and/or adjusted so that the whole lighting module comprising the metallic sheet 200 or 210 fits inside the free volume of a housing -e.g. of a lighting device- within which the lighting module is to be included.

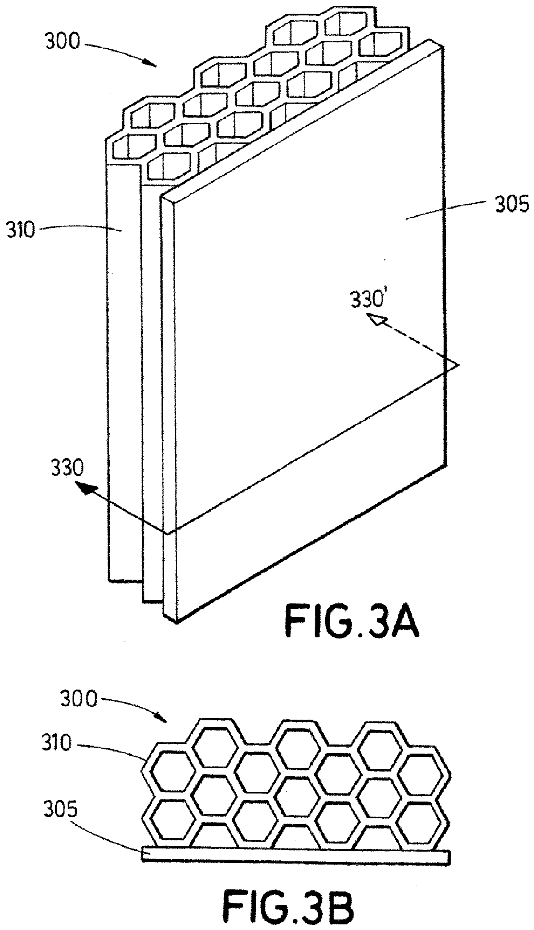

Figures 3A-3B show a lighting module 300 in accordance with another embodiment of the invention; Figure 3B shows the cross-section of the lighting module 300 taken along line 330-330'.

The lighting module 300 comprises a PCB 305 and heat dissipation means, said means in turn comprising a metallic sheet 310. The lighting module 300 also comprises means (not illustrated) for attaching an optical device (not illustrated) to the printed circuit board 105, means (not illustrated) for attaching the lighting module 300 to a lighting device (not illustrated), and a light source (not illustrated).

The metallic sheet 310 features a honeycomb geometry. Such geometry may be achieved, for example, with a shaping process such as stamping or cutting.

Accordingly, the metallic sheet 310 is shaped so as to comprise a first portion with a plurality of planar surfaces whereby it sticks to the PCB 305, and a second portion with a surface adapted to dissipate heat in the form of the honeycomb shape.

A thermal adhesive may be interposed between the PCB 305 and the planar surfaces so as to increase the thermal conductivity between the two and, hence, achieve a higher heat transfer towards the metallic sheet 310.

In some embodiments, the printed circuit boards 105 and 305 comprise a substrate suitable for electronic applications, for instance FR4 with a standard thickness -e.g. 1 millimeter, 1.6 millimeters, 2.4 millimeters- or a non-standard thickness.

In some other embodiments, the PCBs 105 and 305 comprise a metal core PCB. The use of a metal core PCB may enhance the heat transfer between the PCB and the heat dissipation means since the metal core is, generally, a good thermal conductor. Therefore, the metal core may spread and transfer heat and thus improve the heat dissipation.

In this text, the term "comprises" and its derivations (such as "comprising", etc.) should not be understood in an excluding sense, that is, these terms should not be interpreted as excluding the possibility that what is described and defined may include further elements, steps, etc.

The invention is obviously not limited to the specific embodiment(s) described herein, but also encompasses any variations that may be considered by any person skilled in the art (for example, as regards the choice of materials, dimensions, components, configuration, etc.), within the general scope of the invention as defined in the claims.

## Claims

1. Lighting module (100, 300) for an automotive vehicle, comprising:
a printed circuit board (105, 305); and
heat dissipation means comprising at least one metallic sheet (110, 200, 210, 310);
wherein the at least one metallic sheet (110, 200, 210, 310) is stuck on the printed circuit board (105, 305); and
wherein the at least one metallic sheet (110, 200, 210, 310) comprises at least a first portion (201, 211) and a second portion (202, 212) which are not coplanar with each other.

2. Lighting module (100, 300) according to claim 1, wherein the printed circuit board (105, 305) comprises at least one of:
means (120) for attaching an optical device to the printed circuit board (105, 305); and
means (125) for attaching the lighting module (100, 300) to a lighting device.

3. Lighting module (100, 300) according to claim 2, wherein the heat dissipation means do not comprise any heat dissipation element formed by metal injection molding.

4. Lighting module (100, 300) according to any of claims 1-3, wherein the heat dissipation means further comprise an adhesive interposed between the at least one metallic sheet (110, 200, 210, 310) and the printed circuit board (105, 305), the adhesive being preferably a thermal adhesive.

5. Lighting module (100, 300) according to any of claims 1-4, wherein the at least one metallic sheet (110, 200, 210, 310) comprises one of: aluminum, copper, and an alloy thereof.

6. Lighting module (100, 300) according to any of claims 1-5, wherein the at least one metallic sheet (110, 200, 210, 310) is shaped into the at least first portion (201, 211) and the at least second portion (202, 212) by means of one of: folding, bending, stamping, cutting, and a combination thereof.

7. Lighting module (100, 300) according to any of claims 1-6, wherein the at least first portion (201, 211) comprises a planar surface adapted to stick on the printed circuit board (105, 305), and the at least second portion (202, 212) comprises a surface adapted to dissipate heat, the surface adapted to dissipate heat preferably comprising one of a twisted surface, a curved surface, an accordion shape and a honeycomb shape.

8. Method for producing a lighting module (100, 300) for an automotive vehicle, comprising:
providing a printed circuit board (105, 305);
providing heat dissipation means comprising at least one metallic sheet (110, 200, 210, 310);
shaping the at least one metallic sheet (110, 200, 210, 310) into at least a first portion (201, 211) and a second portion (202, 212) which are not coplanar with each other; and
sticking the at least one metallic sheet (110, 200, 210, 310) on the printed circuit board (105, 305).

9. Method according to claim 8, further comprising providing in the printed circuit board (105, 305) at least one of:
means (120) for attaching an optical device to the printed circuit board (105, 305); and
means (125) for attaching the lighting module (100, 300) to a lighting device.

10. Method according to claim 9, wherein the heat dissipation means do not comprise any heat dissipation element formed by metal injection molding.

11. Method according to any of claims 8-10, wherein sticking the at least one metallic sheet (110, 200, 210, 310) on the printed circuit board (105, 305) comprises interposing an adhesive between the at least one metallic sheet (110, 200, 210, 310) and the printed circuit board (105, 305), the adhesive being preferably a thermal adhesive.

12. Method according to any of claims 8-11, wherein the at least one metallic sheet (110, 200, 210, 310) comprises one of: aluminum, copper, and an alloy thereof.

13. Method according to any of claims 8-12, wherein shaping the at least one metallic sheet (110, 200, 210, 310) comprises one of: folding, bending, stamping, cutting, and a combination thereof.

14. Method according to any of claims 8-13, wherein shaping the at least one metallic sheet (110, 200, 210, 310) comprises:
providing the at least first portion (201, 211) with a planar surface adapted to stick on the printed circuit board (105, 305); and
shaping the at least second portion (202, 212) so as to provide a surface adapted to dissipate heat, the surface adapted to dissipate heat preferably comprising one of a twisted surface, a curved surface, an accordion shape and a honeycomb shape.

15. Lighting device for an automotive vehicle, comprising a lighting module (100, 300) according to any of claims 1-7.
